# DEMANDE DE BREVET EUROPEEN

(11) **EP 2 437 266 A1**
(43) Date de publication de la demande: **04.04.2012**
(21) Numéro de dépôt: 11183553.4
(22) Date de dépôt: 30.09.2011
(51) Int. Cl.: G11C 7/06, G11C 11/419, G11C 11/413, G11C 7/12

(54) **Circuit d'aide à la lecture pour un dispositif mémoire**

(30) Priorité: 30.09.2010 FR 1057945
(71) Demandeur: STmicroelectronics SA, 92120 Montrouge (FR); STMicroelectronics (Crolles 2) SAS, 38920 Crolles (FR); Centre National de la Recherche Scientifique, 75794 Paris Cedex 16 (FR)
(72) Inventeur: Abouzeid, Fady, 38100 Grenoble (FR); Clerc, Sylvain, 38000 Grenoble (FR); Roche, Philippe, 38330 Biviers (FR)
(74) Mandataire: de Beaumont, Michel

(57) **Abrégé**

L'invention concerne un circuit d'aide à la lecture disposé pour renforcer la différence de tension entre une paire de lignes de bit complémentaires (BL, **B̅L̅**) d'un dispositif mémoire pendant une opération de lecture, le circuit d'aide à la lecture comprenant : un premier transistor (302A, 302B) adapté à être commandé par le niveau de tension d'une première ligne de bit de la paire pour coupler la seconde ligne de bit de la paire à une première tension d'alimentation (V_{DD}) ; et un deuxième transistor (312A, 312B), connecté directement à la masse, et adapté à être commandé par le niveau de tension sur la seconde ligne de bit pour coupler la première ligne de bit à la masse.

## Description

### Domaine de l'invention

La présente invention concerne un circuit et un procédé et en particulier un circuit pour améliorer la vitesse des opérations de lecture d'une mémoire et un procédé de mise en oeuvre.

### Exposé de l'art antérieur

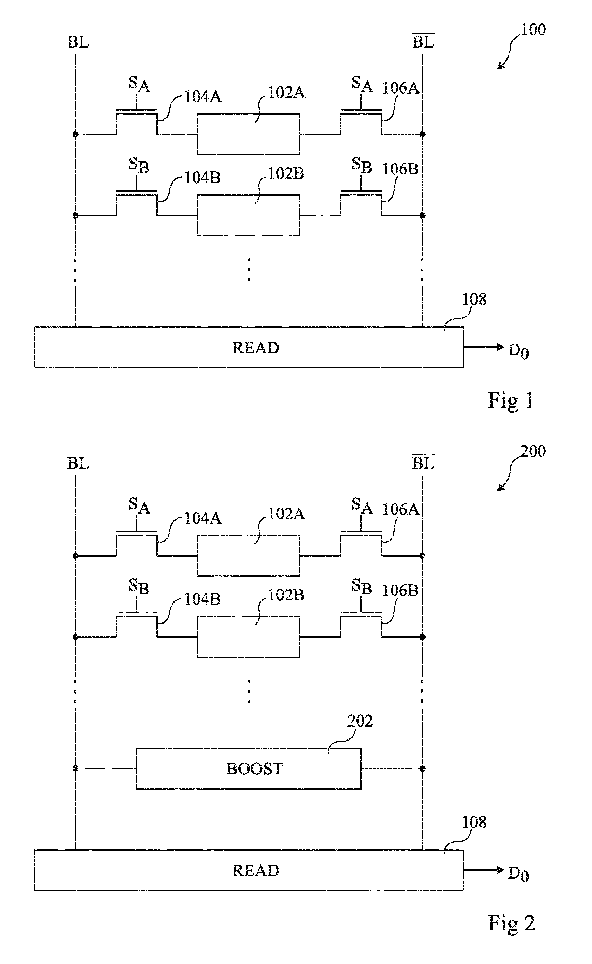

La figure 1 représente une partie 100 d'un dispositif mémoire comprenant des lignes de bit complémentaires BL et **B̅L̅**, et des cellules mémoire 102A, 102B couplées à la ligne de bit BL par des transistors correspondants 104A et 104B et à la ligne de bit **B̅L̅** par des transistors correspondants 106A et 106B. Quand la cellule mémoire 102A ou 102B doit être lue, les lignes de bit BL et **B̅L̅** sont préchargées à un niveau de tension haut, et ensuite les transistors correspondants 104A, 106A ou 104B, 106B sont rendus passants par un signal de commande correspondant S_{A}, S_{B} sur leur grille. Selon la valeur de bit mémorisée dans la cellule mémoire, la tension sur l'une ou l'autre des lignes de bit BL, **B̅L̅** chutera. Un circuit de lecture 108 détecte cette chute de tension et fournit la donnée correspondante D₀.

Un objectif commun de ces dispositifs mémoire est de permettre d'atteindre des opérations de lecture mémoire relativement rapides, pour permettre des débits de lecture de données élevés à partir de la mémoire. La vitesse de l'opération de lecture est limitée par la vitesse à laquelle la tension sur la ligne de bit BL ou **B̅L̅** chute une fois que la cellule mémoire à lire a été couplée aux lignes de bit.

Un autre objectif courant de ces dispositifs mémoire est d'avoir une faible consommation. On a proposé une solution qui consiste à utiliser des tensions d'alimentation basses ou très basses qui réduisent la consommation du dispositif.

Toutefois, l'utilisation de tensions d'alimentation basses présente deux inconvénients principaux. D'abord, cela ralentit la décharge des lignes de bit pendant les opérations de lecture et réduit donc la vitesse des opérations de lecture. Ensuite, en raison du rapport réduit entre les courants dynamiques et de fuite aux faibles tensions d'alimentation, la chute de tension sur BL et **B̅L̅** induite par la fuite des mémoires qui n'ont pas été lues peut être interprétée de façon erronée comme une chute légitime, ce qui conduit à une erreur de lecture en raison du fait que les deux lignes BL et **B̅L̅** seront détectées comme présentant une décroissance de niveau.

### Résumé

Un objet d'un mode de réalisation de la présente invention est de traiter au moins partiellement un ou plusieurs des inconvénients de l'art antérieur.

Selon un aspect de la présente invention, il est prévu un circuit d'aide à la lecture disposé pour renforcer la différence de tension entre une paire de lignes de bit complémentaires d'un dispositif mémoire pendant une opération de lecture. Ce circuit d'aide à la lecture comprend un premier transistor adapté à être commandé par le niveau de tension d'une première ligne de bit de la paire pour coupler la seconde ligne de bit de la paire à une première tension d'alimentation ; et un deuxième transistor, connecté directement à la masse, et adapté à être commandé par le niveau de tension sur la seconde ligne de bit pour coupler la première ligne de bit à la masse.

Selon un mode de réalisation de la présente invention, le circuit d'aide à la lecture comprend en outre un troisième transistor adapté à être commandé par le niveau de tension de la première ligne de bit pour coupler une borne de commande du deuxième transistor à la seconde tension d'alimentation.

Selon un mode de réalisation de la présente invention, le premier transistor est rendu passant par une tension basse de la première ligne de bit et le second transistor est rendu passant par une tension haute de la seconde ligne de bit.

Selon un mode de réalisation de la présente invention, le premier transistor est un transistor MOS à canal P et le deuxième transistor est un transistor MOS à canal N.

Selon un mode de réalisation de la présente invention, le circuit d'aide à la lecture comprend en outre un circuit de désactivation commandable pour empêcher le deuxième transistor de coupler la première ligne de bit à la seconde tension d'alimentation.

Selon un mode de réalisation de la présente invention, le circuit de désactivation comprend un transistor adapté à être commandé par un signal de désactivation et couplé entre le premier transistor et une borne de commande du second transistor.

Selon un mode de réalisation de la présente invention, le circuit de désactivation comprend un autre transistor couplé entre une borne de commande du deuxième transistor et la seconde tension d'alimentation et adapté à être commandé par un signal de désactivation.

Selon un mode de réalisation de la présente invention, le circuit d'aide à la lecture comprend en outre un quatrième transistor adapté à être commandé par le niveau de tension sur la seconde ligne de bit pour coupler la première ligne de bit à la première ligne d'alimentation ; et un cinquième transistor adapté à être commandé par le niveau de tension sur la première ligne de bit pour coupler la seconde ligne de bit à la seconde tension d'alimentation.

Selon un aspect de la présente invention, il est prévu un dispositif mémoire comprenant une pluralité de colonnes dont chacune comprend une pluralité de cellules mémoire couplées entre une paire de lignes de bit complémentaires et le circuit d'aide à la lecture ci-dessus également couplé entre la paire de lignes de bit.

Selon un aspect de la présente invention, il est prévu un dispositif électronique contenant le dispositif mémoire ci-dessus.

Selon un aspect de la présente invention, il est prévu un procédé de renforcement de la différence de tension entre une paire de lignes de bit complémentaires d'un dispositif mémoire pendant une opération de lecture, le procédé comprenant : coupler une cellule mémoire du dispositif mémoire à la paire de lignes de bit complémentaires ; en fonction du niveau de tension sur une première ligne de bit de la paire, coupler par un premier transistor la seconde ligne de bit de la paire à une première tension d'alimentation ; et en fonction du niveau de tension sur la seconde ligne de bit, coupler par un second transistor (312A, 312B), connecté directement à la masse, la première ligne de bit à la masse (GND).

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, décrite ci-dessus, représente schématiquement un exemple d'une partie d'un dispositif mémoire ;
la figure 2 représente schématiquement une partie d'un dispositif mémoire selon un mode de réalisation de la présente invention ;
chacune des figures 3 et 4 représente schématiquement un circuit d'aide à la lecture du dispositif mémoire de la figure 2 selon des modes de réalisation de la présente invention ;
la figure 5 est un chronogramme illustrant un exemple de signaux du circuit d'aide à la lecture des figures 3 et 4 selon un mode de réalisation de la présente invention ; et
la figure 6 représente un dispositif mémoire selon un mode de réalisation de la présente invention.

### Description détaillée

Dans ce qui suit, seuls les aspects utiles à la compréhension de l'invention seront décrits en détail. D'autres caractéristiques, telles que la structure particulière des cellules mémoire des dispositifs mémoire, ne seront pas décrites, l'invention s'appliquant à tout type de cellule mémoire qui utilise la différence de tension entre deux lignes de bit pour réaliser une opération de lecture.

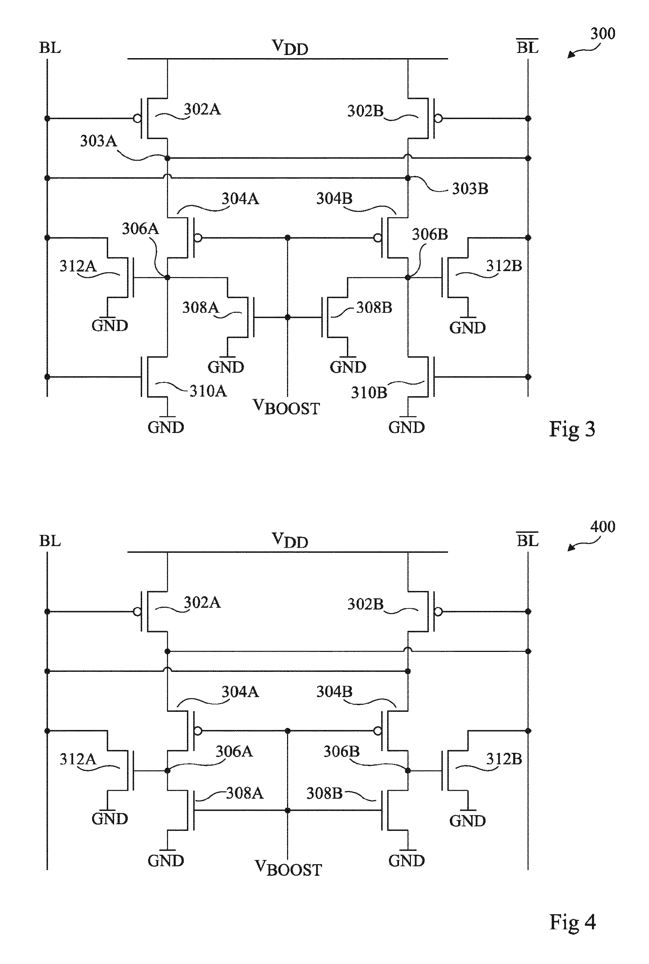

La figure 2 représente une partie 200 d'un dispositif mémoire similaire à la partie 100 de la figure 1 en ce qu'elle comprend les mêmes cellules mémoires 102A, 102B et les lignes de bit BL et **B̅L̅** ainsi que les transistors 104A, 104B, 106A, 106B. La partie 200 comprend en outre un circuit d'aide à la lecture 202 couplé entre les lignes de bit complémentaires BL et **B̅L̅** pour renforcer la différence de tension présente sur les lignes de bit BL et **B̅L̅** pendant une opération de lecture, comme cela sera maintenant décrit plus en détail en faisant référence aux schémas de circuit des figures 3 et 4.

La figure 3 représente schématiquement un mode de réalisation 300 du circuit d'aide à la lecture 202 de la figure 2.

Le circuit d'aide à la lecture 300 comprend des transistors MOS à canal P (PMOS) 302A et 302B dont chacun comporte une borne de commande couplée aux lignes de bit BL et **B̅L̅**, respectivement. Le transistor 302A est couplé entre une tension d'alimentation V_{DD} et un noeud 303A, lui-même couplé à une ligne de bit **B̅L̅** et, par l'intermédiaire d'un transistor PMOS 304A, à un noeud 306A. De façon similaire, le transistor 302B est couplé entre la tension d'alimentation V_{DD} et un noeud 303B lui-même couplé à la ligne de bit BL et, par un transistor PMOS 304B, à un noeud 306B. Les noeuds 306A et 306B sont couplés à la masse par des transistors NMOS 308A, 308B, respectivement et par des transistors NMOS 310A, 310B respectivement. Les bornes de commande des transistors 304A, 304B, 308A et 308B sont commandées par une tension de commande V_{BOOST}- Les bornes de commande des transistors 310A, 310B sont couplées aux lignes de bit BL et **B̅L̅** respectivement. En outre, un transistor NMOS 312A est couplé entre la ligne de bit BL et la tension de masse GND et a sa borne de commande couplée au noeud 306A. De façon similaire, un transistor NMOS 312B est couplé entre la ligne de bit **B̅L̅** et une tension de masse GND et a sa borne de commande couplée au noeud 306B.

Les transistors 302A et 310A réalisent une lecture préliminaire de l'état de la ligne de bit BL tandis que les transistors 302B et 310B réalisent une lecture préliminaire de l'état de la ligne de bit **B̅L̅**. Dans le cas où la ligne de bit BL est à niveau bas pendant une opération de lecture, les transistors 302A et 312A ont également pour rôle de renforcer cet état, en appliquant la tension d'alimentation V_{DD} à la ligne de bit **B̅L̅** et en couplant la ligne de bit BL à la tension de masse GND. De façon similaire, dans le cas où la ligne de bit **B̅L̅** est à niveau bas pendant une opération de lecture, les transistors 302B et 312B ont également pour rôle de renforcer cet état en appliquant la tension d'alimentation V_{DD} à la ligne de bit BL, et en couplant la ligne de bit **B̅L̅** à la tension de masse GND. Le terme "renforcer" est utilisé pour désigner à la fois une augmentation de la tension de la ligne de bit vers la tension d'alimentation et une diminution de la tension de la ligne de bit vers le niveau de la masse.

En outre, un circuit de désactivation est prévu pour désactiver cette fonction. Dans l'exemple de la figure 3, le circuit de désactivation comprend des transistors 304A, 304B, tandis que les transistors 308A et 308B maintiennent les tensions des noeuds 306A et 306B au niveau de la masse quand la fonction d'aide est désactivée.

Les transistors 310A et 310B, qui sont optionnels, ont également pour rôle de maintenir les états de tension sur les noeuds 306A, 306B, respectivement, à la tension de la masse de sorte que le renforcement des tensions des lignes de bit est retardé jusqu'à ce que les tensions des lignes de bit aient transité vers un état différentiel.

En fonctionnement, l'opération d'aide à la lecture est mise en oeuvre en trois phases : activation, lecture préliminaire et renforcement.

Le circuit d'aide à la lecture 300 est activé pendant une opération de lecture par un niveau bas de la tension de commande V_{BOOST}, rendant ainsi passants les transistors 304A et 304B et désactivant les transistors 308A, 308B. Après charge des lignes de bit BL et **BL** au début de l'opération de lecture, par exemple à la tension d'alimentation V_{DD}, et activation de la sortie de la cellule mémoire à lire (non représentée en figure 3), la tension sur la ligne de bit BL ou la ligne de bit **BL** commencera à chuter, selon la valeur de bit lue.

En supposant que c'est la tension sur la ligne de bit BL qui chute, le transistor 302A sera rendu passant. Ceci appliquera la tension d'alimentation V_{DD} à la ligne de bit **BL** et couplera le noeud 306A à la tension d'alimentation V_{DD} par le transistor 304A, appliquant ainsi une tension haute à la borne de commande du transistor 312A. Le transistor 312A sera donc rendu passant pour coupler la ligne de bit BL à la masse. En même temps, le transistor 310B sera rendu passant par la tension haute sur la ligne de bit **BL,** couplant ainsi également le noeud 306B et la ligne de bit BL à la masse.

En supposant que c'est la tension sur la ligne de bit **BL** qui chute, le transistor 302B sera rendu passant. Ceci appliquera la tension d'alimentation V_{DD} à la ligne BL et couplera le noeud 306B à la tension d'alimentation V_{DD} par le transistor 304B, appliquant ainsi une tension haute à la borne de commande du transistor 312B. Le transistor 312B sera en conséquence rendu passant pour coupler la ligne de bit **BL** à la masse. En même temps, le transistor 310A sera rendu passant par la tension haute sur la ligne de bit BL, couplant ainsi également le noeud 306A et la ligne de bit **B̅L̅** à la masse.

La figure 4 représente un mode de réalisation 400 du circuit d'aide à la lecture 202 de la figure 2 qui est identique au circuit 300 de la figure 3 sauf que les transistors 310A et 310B sont supprimés.

Le fonctionnement du circuit 400 de la figure 4 est similaire à celui du circuit 300 de la figure 3 sauf que, en raison de la suppression des transistors 310A, 310B, pendant une lecture, il n'y aura pas de retard avant le renforcement des tensions des lignes de bit.

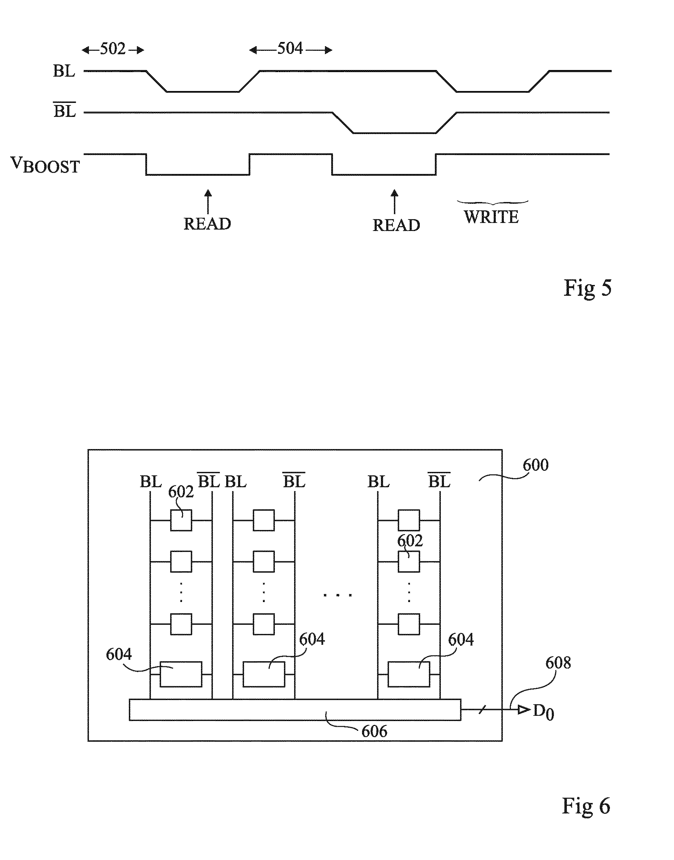

La figure 5 représente des chronogrammes des tensions BL, **B̅L̅** et V_{BOOST} des circuits des figures 3 et 4 selon un exemple.

Pendant une période initiale 502, les deux lignes de bit BL et **B̅L̅** sont préchargées à tension haute et le circuit d'aide à la lecture est désactivé par un niveau haut de la tension de commande V_{BOOST}.

A la fin de la période 502, la tension de commande V_{BOOST} est amenée à niveau bas pour activer le circuit d'aide à la lecture, et une cellule mémoire à lire est couplée aux lignes de bits BL et **B̅L̅**. Dans cet exemple, la ligne de bit BL passe à niveau bas et la vitesse de descente de cette tension est augmentée par le circuit d'aide à la lecture. En raison de la chute de courant des autres cellules mémoires de la colonne qui ne sont pas en train d'être lues, la tension sur la ligne de bit **B̅L̅** peut également chuter au cours du temps mais, en raison du couplage des transistors 302A et 302B aux lignes de bit BL et **B̅L̅**, respectivement, ce phénomène est évité en couplant la ligne de bit **B̅L̅** à la tension d'alimentation. Les tensions sur les lignes de bit peuvent alors être lues, comme cela est indiqué par une flèche désignée par "READ".

Une opération de lecture ultérieure, par exemple d'une autre cellule mémoire, est alors réalisée en mettant à niveau haut la tension de commande VBOOST pendant une période 504 et en préchargeant les lignes de bit BL et B̅L̅. La tension de commande V_{BOOST} est alors amenée à niveau bas et, dans cet exemple, c'est la tension de la ligne de bit B̅L̅ qui chute alors, la vitesse de descente étant accélérée par le circuit d'aide à la lecture.

Une opération d'écriture est alors réalisée en amenant le signal de commande V_{BOOST} à niveau haut, ce qui permet d'appliquer une impulsion de tension aux lignes de bit BL et B̅L̅. Dans cet exemple, un niveau de tension légèrement négatif est appliqué à la ligne de bit BL. Le circuit d'aide à la lecture est par exemple activé seulement pendant des opérations de lecture.

La figure 6 représente un dispositif mémoire 600 comprenant un réseau de cellules mémoire 602 disposées en colonnes entre des lignes de bit complémentaires BL et B̅L̅. Chaque colonne comprend un circuit d'aide à la lecture correspondant 604 couplé aux lignes de bit complémentaires BL et B̅L̅. Le circuit de lecture 606 est couplé à chaque paire de lignes de bit et fournit une valeur de données de sortie à plusieurs bits sur une ligne de sortie 608 de la mémoire.

Le dispositif mémoire 600 pourrait être une SRAM (mémoire statique à accès aléatoire), une DRAM (RAM dynamique), une ROM (mémoire morte), une mémoire Flash ou autre type de dispositif mémoire utilisant une différence entre deux lignes de bit pour réaliser une opération de lecture. Le dispositif mémoire 600 pourrait correspondre à un milieu de mémorisation portable, une commande de disque dur, une clé USB ou une carte mémoire, une mémoire embarquée ou autre type de dispositif électronique à mémoire.

Un avantage des modes de réalisation décrits ici est que la vitesse de chute de tension sur l'une des lignes de bit pendant l'opération de lecture est augmentée, en même temps que l'on assure que la tension sur l'autre ligne de bit ne chute pas également.

En particulier, les transistors 312A, 312B sont tous deux connectés directement entre les lignes de bit respectives BL, **B̅L̅** et la tension de masse GND. Ces transistors 312A, 312B pilotent une ligne de bit au niveau de la tension basse plus vite que les transistors dans la cellule mémoire, telle que la cellule 102A ou 102B de la figure 1. En fait, les transistors des cellules mémoires sont couplés en série avec les transistors 104A, 104B ce qui diminue la durée de décharge des lignes de bit, en particulier quand des tensions basses ou très basses sont utilisées.

En outre, un avantage des modes de réalisation des figures 3 et 4 est que, en raison du couplage direct des transistors 312A et 312B à la masse, ces modes de réalisation peuvent être particulièrement adaptés à des applications à tension basse ou très basse, par exemple quand la tension d'alimentation V_{DD} est comprise entre 0,2 et 1,2 volts.

Alors que divers modes de réalisation particuliers de la présente invention ont été décrits, il sera clair pour l'homme de l'art que de nombreuses variantes et modifications pourraient être mises en oeuvre.

Par exemple, le chronogramme de la figure 5 est uniquement un exemple. D'autres répartitions temporelles des tensions étant possibles pendant des opérations de lecture et d'écriture.

En outre, bien que les circuits 300 et 400 des figures 3 et 4 comprennent des transistors MOS, dans des variantes de réalisation, d'autres types de transistors pourraient être utilisés, et les transistors NMOS pourraient être remplacés par des transistors PMOS et réciproquement.

## Revendications

1. Circuit d'aide à la lecture disposé pour renforcer la différence de tension entre une paire de lignes de bit complémentaires (BL, **B̅L̅**) d'un dispositif mémoire pendant une opération de lecture, le circuit d'aide à la lecture comprenant :
un premier transistor (302A, 302B) adapté à être commandé par le niveau de tension d'une première ligne de bit de la paire pour coupler la seconde ligne de bit de la paire à une première tension d'alimentation (V_{DD}) ; et
un deuxième transistor (312A, 312B), connecté directement à la masse, et adapté à être commandé par le niveau de tension sur la seconde ligne de bit pour coupler la première ligne de bit à la masse.

2. Circuit d'aide à la lecture selon la revendication 1, comprenant en outre un troisième transistor (310A, 310B) adapté à être commandé par le niveau de tension de la première ligne de bit pour coupler une borne de commande du deuxième transistor à la seconde tension d'alimentation.

3. Circuit d'aide à la lecture selon la revendication 1 ou 2, dans lequel le premier transistor est rendu passant par une tension basse de la première ligne de bit et le second transistor est rendu passant par une tension haute de la seconde ligne de bit.

4. Circuit d'aide à la lecture selon l'une quelconque des revendications 1 à 3, dans lequel le premier transistor est un transistor MOS à canal P et le deuxième transistor est un transistor MOS à canal N.

5. Circuit d'aide à la lecture selon l'une quelconque des revendications 1 à 4, comprenant en outre un circuit de désactivation (304A, 304B, 308A, 308B) commandable pour empêcher le deuxième transistor de coupler la première ligne de bit à la seconde tension d'alimentation (GND).

6. Circuit d'aide à la lecture selon la revendication 5, dans lequel le circuit de désactivation comprend un transistor (304A, 304B) adapté à être commandé par un signal de désactivation (V_{BOOST}) et couplé entre le premier transistor et une borne de commande du second transistor.

7. Circuit d'aide à la lecture selon la revendication 5 ou 6, dans lequel le circuit de désactivation comprend un autre transistor (308A, 308B) couplé entre une borne de commande du deuxième transistor et la seconde tension d'alimentation et adapté à être commandé par un signal de désactivation (V_{BOOST}).

8. Circuit d'aide à la lecture selon l'une quelconque des revendications 1 à 7, comprenant en outre :
un quatrième transistor (302B, 302A) adapté à être commandé par le niveau de tension sur la seconde ligne de bit pour coupler la première ligne de bit à la première ligne d'alimentation (V_{DD}) ; et
un cinquième transistor (312B, 312A) adapté à être commandé par le niveau de tension sur la première ligne de bit pour coupler la seconde ligne de bit à la seconde tension d'alimentation (GND).

9. Dispositif mémoire comprenant une pluralité de colonnes dont chacune comprend une pluralité de cellules mémoire (602) couplées entre une paire de lignes de bit complémentaires (BL, **B̅L̅**) et le circuit d'aide à la lecture selon l'une quelconque des revendications 1 à 8 également couplé entre la paire de lignes de bit.

10. Dispositif électronique contenant le dispositif mémoire de la revendication 9.

11. Procédé de renforcement de la différence de tension entre une paire de lignes de bit complémentaires (BL, **B̅L̅**) d'un dispositif mémoire pendant une opération de lecture, le procédé comprenant :
coupler une cellule mémoire du dispositif mémoire à la paire de lignes de bit complémentaires ;
en fonction du niveau de tension sur une première ligne de bit de la paire, coupler par un premier transistor (302A, 302B) la seconde ligne de bit de la paire à une première tension d'alimentation (V_{DD}) ; et
en fonction du niveau de tension sur la seconde ligne de bit, coupler par un second transistor (312A, 312B), connecté directement à la masse, la première ligne de bit à la masse (GND).
